# EUROPEAN PATENT APPLICATION

(11) **EP 0 652 515 A1**
(43) Date of publication of application: **10.05.1995**
(21) Application number: 94307690.1
(22) Date of filing: 19.10.1994
(51) Int. Cl.: G06F 11/00, G06F 11/20

(54) **Memory device, manufacture of such a device and a method of simulating a contiguous memory**

(30) Priority: 09.11.1993 GB 9323096
(71) Applicant: LUCAS INDUSTRIES PUBLIC LIMITED COMPANY, Solihull, West Midlands B91 3TX (GB)
(72) Inventor: Hodgson, Duncan Barry, Solihull, West Midlands B95 6JB (GB); Waite, Lee, Sutton Coldfield, West Midlands B72 1RR (GB); Roughton, Michael George, Solihull, West Midlands, B90 1AX (GB)
(74) Representative: Robinson, John Stuart

(57) **Abstract**

A memory device (1) comprises a plurality of memory blocks (4, 6, 8, 10) formed in a common substrate (30) and a memory manager (2). The memory manager (2) tests the memory blocks to identify working pages of memory and stores the addresses of the working pages in a further memory (46). Access to the working pages is then controlled by the memory manager (2) so as to simulate a contiguous area of memory.

## Description

The present invention relates to a memory device, the manufacture of such a device and a method of simulating a contiguous memory.

A semiconductor wafer may carry a plurality of memory modules. If the modules are connected to a common power supply rail, a short circuit within a module can cause the entire wafer to become unusable.

Integrated circuit manufacturing techniques for devices, such as semiconductor memories, tend to provide yields of about 20% to 40%, the remaining devices being either totally or partially defective. However, effective yields could be increased if partially defective devices could also be used.

EP 0 541 288 A discloses an arrangement in which a plurality of devices arranged in modules is fabricated on a wafer. A set of discretionary connections are associated with each of the modules and with interconnect/power segments associated with respective ones of the modules. Connections are made or broken in a multilayer structure of the substrate after a module has been tested. Thus the connections are made by the manufacturer of the wafer. Such an arrangement has little or no scope for subsequent reworking of the connections.

US 4 703 436 discloses an arrangement in which a plurality of devices is formed in a matrix in a wafer. Each device is tested and thereafter a conductive grid is formed on the wafer to interconnect all the functional and partially functional circuits of the wafer. Each matrix row includes redundant decoder lines which are programmed to reassign functional circuits from a semiconductor wafer substrate location to a matrix row location in another matrix having defective circuits. Thus complete functional matrix rows may be formed. Associated input and output lines are similarly assigned. The assignment has to be done during the manufacture of the device. Also the device cannot be further updated to take account of further faults occurring after manufacture.

According to a first aspect of the present invention, there is provided a memory device, comprising a plurality of memory blocks and a memory manager arranged to test the memory blocks to identify working pages of memory within the memory blocks, to store addresses of the working pages within a further memory and to control access to the working pages in accordance with the addresses stored in the further memory so as to simulate a contiguous area of memory.

Thus fully functional and partially functional blocks of memory can be combined together to simulate a fully functioning memory. Furthermore, the blocks may be regularly tested and the arrangement of the blocks within the simulated memory may be dynamic. Thus the memory manager can cope with failure of blocks of memory occurring after manufacture of the device.

According to a second aspect of the invention there is provided a method of simulating a contiguous area of memory from a plurality of functioning memory pages distributed among a plurality of fully functional and partially functional memory devices, comprising testing the memory devices to identify working pages of memory, storing the addresses of the working pages within a further memory, and mapping the addresses of the working pages so as to simulate a contiguous area of memory.

According to a third aspect of the present invention there is provided a method of manufacturing a memory device, comprising the steps of forming a plurality of memory blocks within a single substrate, testing the individual memory blocks to identify fully functioning and partially functioning memory blocks, connecting the fully and partially functioning memory blocks to power rails of the memory device, and connecting the memory blocks to a memory controller, the memory controller being arranged to test the memory blocks to identify usable pages of memory within the memory blocks and to map the usable pages to simulate a contiguous memory.

The term "page" as used hereinabove refers to a small area of memory, for example, a block of 1024 addresses, although other page sizes (generally being a power of 2) may be chosen.

The term "contiguous" as used herein refers to an area of memory that appears to be continuous, i.e. no missing addresses, even though the memory may be physically divided between a plurality of memory devices and the memory capability within those devices may have missing addresses.

Preferably the memory blocks are formed within a common substrate. Advantageously at least one of the power supply rails to each block is left unconnected until the respective block has been tested to determine if it is fully functional, partially functional or non-functional. Only fully and partially functional blocks are subsequently connected to the power supply rails.

Preferably the memory manager has a plurality of registers, one register being associated with each page of memory. Advantageously each register has a first bit to indicate whether the page is usable. Each register may further contain a second bit to indicate whether or not a page contains one or more correctable single bit errors.

Preferably the memory manager interfaces between the or each device using the memory and the pages within the memory so as to simulate a fully functioning memory. Preferably the memory manager is transparent in operation.

Preferably the memory manager repeatedly updates a record of the status of the memory pages. The memory manager may test each of the memories during a power-up sequence and configure the memories in response to the result of the power-up test.

The memory blocks may be electrically arranged in groups, blocks within each group sharing an address bus.

Preferably the memory manager is arranged to generate error correction codes when writing data to the memory and to check the data against its respective error correction code when reading data from the memory so as to check the integrity of the data and to correct for single bit errors.

In one embodiment of a memory device, the memory manager is arranged to control twelve memories. Each memory is a 128k x 8 random access memory. The memories are connected in groups of three so as to provide four blocks of 128k x 22 bit memory (16 data bits, 6 error correction bits, 2 spare bits)

The present invention will further be described, by way of example, with reference to the accompanying drawings, in which:
Figure 1 is a block diagram of a memory device constituting an embodiment of the present invention;
Figure 2 is a perspective view of a memory device constituting an embodiment of the present invention; and
Figure 3 shows an exemplary cross section through the device shown in Figure 2.

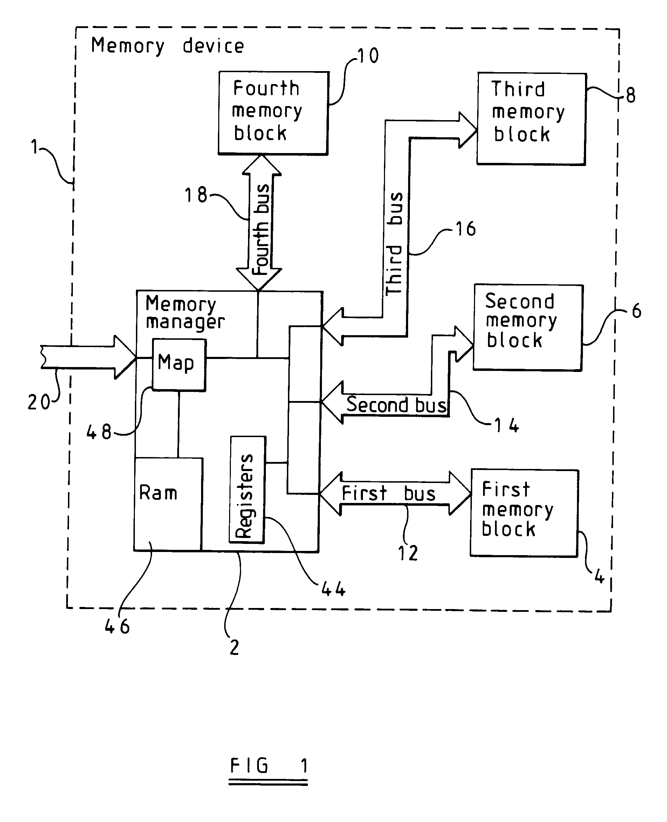

As shown in Figure 1, a memory device 1 comprises a memory manager 2 connected to first to fourth blocks of memory 4, 6, 8 and 10 by first to fourth address, data and control busses 12, 14, 16 and 18, respectively. Each of the blocks comprises memory arranged in a plurality of pages. Each page may, for example, be 1024 words long. The memory manager 2 is connected to address and data busses for connecting the memory device 1 to other elements, such as a CPU (not shown).

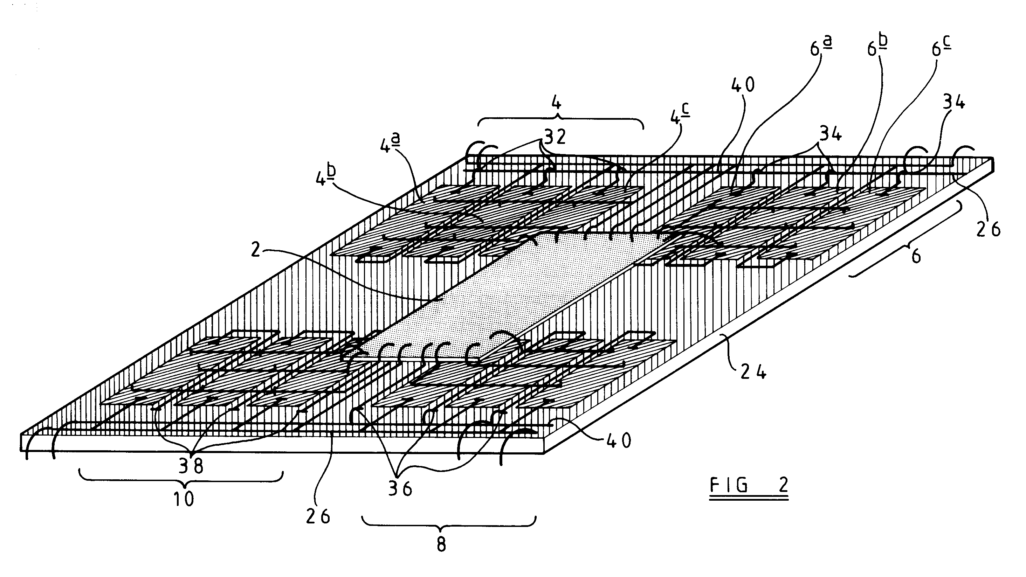

The blocks of memory are formed within a semiconductor wafer 24 of approximately 40mm by 40mm, as shown in Figure 2. The first block of memory 4 comprises three individual memory chips 4a, 4b and 4c formed within the body of the wafer 24. The second block of memory 6 comprises a further three memory chips 6a, 6b and 6c formed within the body of the wafer, and so on for the third and fourth blocks of memory. Each individual memory chip is formed with its ground terminal connected to a ground rail 26 formed at either side of the wafer 24. The memory chips in each block are arranged to cooperate so as to provide a memory having a word length of 22 bits (24 bits with 2 bits unused).

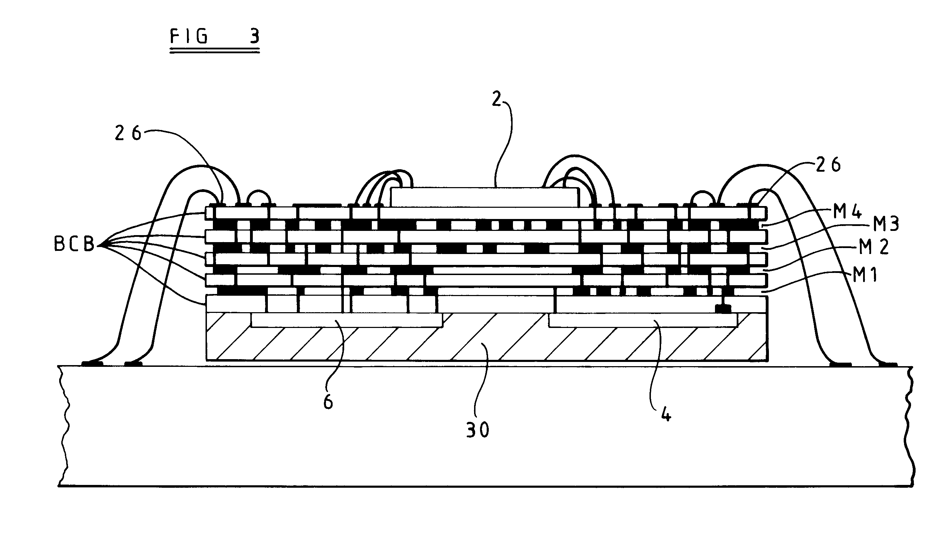

The memory manager 2 is mounted on the surface of the wafer 24. The memory manager is connected to each block by respective address, data and control busses formed by metallic paths within a multilayer structure of the wafer, as shown in Figure 3 and as illustrated by the connections running between the memory manager 2 and the memories 4, 6, 8 and 10 in Figure 2. Four layers of conductors are sandwiched between insulating layers so as to provide connections between devices on the surface of the wafer 24 and the memories formed within a substrate 30.

During manufacture, the substrate 30 is planarised by depositing a layer of polymer, such as polyamide or benzocyclobutene (BCB) 10 microns thick on the surface of the substrate. The polymer is then etched using photo-lithographic techniques to expose wire bond pads of each RAM die 4a, 4b, 4c, 6a, etc. A layer M1 of aluminium is then deposited on the surface of the die and etched using photo-lithographic techniques to form conducting tracks for power, ground, address, data and control lines to connect with each RAM die. A second layer of polymer is then deposited and etched to expose connection pads to which a second layer M2 of aluminium is then deposited and etched so as to provide a second layer of conducting tracks connecting with the first layer. The first and second layers are application specific, i.e. dictated by the number of and positions of the RAM dies. Further layers of polymer and aluminum M3 and M4 are deposited, culminating with an uppermost layer of polymer, and etched to provide connections to the memory manager 2 on the surface of the wafer 24 and to other devices, such as other memory devices or application specific integrated circuits (ASIC) mounted on the wafer 24.

The ground rail pattern is defined in the first layer M1. Similarly a power rail pattern is also defined in M1, with occasional jumps to M2 where the power rail is required to cross the ground rail. The ground and power rails are brought up to the surface of the wafer at the edges thereof, as shown in Figures 2 and 3.

The address, data and control lines for each block of memory are also defined within the layers M1 and M2, but are brought to the surface of the wafer 24 in the vicinity of the memory manager 2. The memory manager is connected to the address, data and control lines by wire bonding, TAB or flip chip techniques. The layers M3 and M4 may be used to define track patterns for other devices mounted on the surface of the wafer.

One failure mode for a circuit fabricated within a wafer is a short circuit between the power and ground rails. Such a short would cause failure of the whole package if the power and ground rails were permanently connected during the metallisation process. To overcome this, each block of memory 4, 6, 8, 10 is initially not connected to a power rail but has a power supply line brought up to respective bonding pads 32, 34, 36 and 38 on the surface of the wafer 24. Similarly a power rail 40 is formed on the surface of the wafer 24. After fabrication, each memory block is tested to check if it has a power rail to ground short circuit. Only those groups which do not have a short circuit are connected to the power supply by a wire bonded from the respective bond pad 32, 34, 36 and 38 to the power rail 40. In Figure 2, the fourth memory block 10 does not have a connection to the power rail 40.

The memory manager 2 is arranged to test each memory block 4,6,8 and 10 (not powered) on power-up, to reject pages of faulty memory and to configure the good pages of memory so as to present a continuous block of functional memory to a device, such as a processor (CPU), wishing to access the memory. The memory of the memory device 1 is configured as 16 bits wide. If any memory block 4, 6, 8, 10 is totally unusable, such as the fourth block 10 in this example, then the address, data and control lines to that block are permanently set to a high impedance state. Such setting to a permanent high impedance state may be achieved by a hard wired connection to the memory manager 2. If all the memory is functional, the memory manager 2 can access 512 pages of 1K length by 22 bits wide.

During power-up, each page of memory is tested under control of the memory manager 2 and the results stored in a plurality of two bit registers 44, one register for each individual page, within the memory manager 2. A first bit is used to indicate if the page is unusable due, for example, to addressing faults or uncorrectable multiple bit errors. The second bit is used to indicate if the page contains one or more correctable single bit errors.

Following completion of the power-up test, the memory manager writes the start addresses of totally error free pages into an internal memory 46. The internal memory 46 contains 384 words, each word being 15 bits (9 data bits and 6 error correction bits). If there are less than 384 error free pages, then the remaining space within the internal memory 46 is filled with the addresses of pages having correctable single bit errors. Thus a maximum of 768 Kilobytes of memory (available as 384K addresses of 16 bit words) is available for use. The number of error free pages, the number of pages having correctable errors and the current state of the testing/configuration process is held in registers which may be read by an external device.

The internal memory 46 is used as a look up table to enable a mapping means within the memory manager 2 to translate the address requested, for example, by a CPU, to the actual address required to access a corresponding address within a relevant memory 4,6, 8, 10. Such processing is transparent to the CPU or other device accessing the memory.

The memory manager 2 is also arranged to perform error detection and correction on the memory blocks and the internal memory. An error correction code is generated on every memory write operation and checked on every memory read operation.

It is thus possible to provide a memory device which enables partially functioning memory circuits to be used. Also, progressive failures are checked for and accommodated, thus providing a device which is relatively fault tolerant.

## Claims

1. A memory device comprising a plurality of memory blocks (4, 6, 8, 10), characterised by a memory manager (2) arranged: to test the memory blocks (4, 6, 8, 10) to identify working pages of memory within the memory blocks (4, 6, 8, 10); to store addresses of the working pages within a further memory (46); and to control access to the working pages in accordance with the addresses stored in the further memory (46) so as to simulate a contiguous area of memory.

2. A device as claimed in Claim 1, characterised in that the memory blocks (4, 6, 8, 10) are formed within a common substrate (30).

3. A device as claimed in Claim 1 or 2, characterised by a power supply rail (40) which is connected only to each of the memory blocks (4, 6, 8) which is at least partially functional.

4. A device as claimed in any one of the preceding claims, characterised in that the memory manager (2) has a plurality of registers (44), each of which is associated with a respective memory page of the memory blocks (4, 6, 8, 10).

5. A device as claimed in Claim 4, characterised in that each of the registers (44) has a first bit for indicating whether the respective memory page is usable.

6. A device as claimed in Claim 4 or 5, characterised in that each of the registers (44) has a second bit for indicating whether the respective memory page contains a correctable error.

7. A device as claimed in any one of the preceding claims, characterised in that the memory manager (2) is arranged to update repeatedly a record of the status of the memory pages.

8. A device as claimed in Claim 7, characterised in that the memory manager (2) is arranged to perform the updating each time when power is applied to the device (1).

9. A device as claimed in any one of the preceding claims, characterised in that the memory blocks (4, 6, 8, 10) are electrically arranged in groups with the memory blocks of each group sharing a respective common address bus.

10. A device as claimed in any one of the preceding claims, characterised in that the memory manager (2) is arranged to generate error correction codes when writing data to the memory blocks (4, 6, 8, 10); to check data read from the memory against the respective correction code; and to correct an error in the read data by means of the respective correction code.

11. A method of simulating a contiguous area of memory from a plurality of functioning memory pages distributed among a plurality of at least partially functional memory blocks, comprising the steps of:
(a) testing the memory blocks to identify functioning pages of memory;
(b) storing the addresses of the functioning pages within a further memory; and
(c) mapping the addresses of the functioning pages so as to simulate a contiguous area of memory.

12. A method as claimed in Claim 11, characterised in that the step (a) includes temporarily applying power to the memory blocks and characterised by the further step of making a permanent power supply connection to each memory block which is at least partially functional.

13. A method as claimed in Claim 11 or 12, characterised in that the steps (a) to (c) are performed repeatedly.

14. A method as claimed in Claim 13, characterised in that the steps (a) to (c) are performed each time power is applied to the memory blocks.

15. A method of manufacturing a memory device, comprising the steps of:
forming a plurality of memory blocks within a single substrate;
testing the individual memory blocks to identify at least partially functioning memory blocks;
connecting each at least partially functioning memory block to power rails of the memory device;
testing the memory blocks to identify usable pages of memory; and
mapping the usable pages to simulate a contiguous memory.
